# EUROPEAN PATENT APPLICATION

(11) **EP 4 822 700 A1**
(43) Date of publication of application: **14.10.2026**
(21) Application number: 26166533.5
(22) Date of filing: 20.03.2026
(51) Int. Cl.: G11C 29/02

(54) **MEMORY DEVICE PERFORMING CHIP SELECT SIGNAL TRAINING OPERATION AND OPERATION METHOD FOR CHIP SELECT SIGNAL TRAINING**

(30) Priority: 11.04.2025 KR 20250047624; 25.09.2025 KR 20250138953
(71) Applicant: Samsung Electronics Co., Ltd., Suwon-si, Gyeonggi-do 16677 (KR)
(72) Inventor: LEE, Seung-Jun, 16677 Suwon-si (KR); JANG, Jinhun, 16677 Suwon-si (KR); UM, Youngdo, 16677 Suwon-si (KR); KIM, Ki-Heung, 16677 Suwon-si (KR)
(74) Representative: Marks & Clerk LLP

(57) **Abstract**

A memory device that performs a training operation on a chip select signal includes a clock divider receiving a clock signal from a host and dividing the clock signal to generate at least two internal clock signals, an internal clock selector receiving the at least two internal clock signals from the clock divider and selecting one of the at least two internal clock signals as a target internal clock signal to sample one of a high level or a low level of the chip select signal, and a sampler receiving the chip select signal from the host, receiving the target internal clock signal from the internal clock selector, and sampling the chip select signal using the target internal clock signal.

## Description

### BACKGROUND

Mobile devices such as smartphones, tablet PCs, digital cameras, MP3 players, PDAs, and wearable devices are widely used. In line with mobile technology trends, semiconductor memory devices used in mobile devices are being developed for high integration, enhanced performance, and low power consumption. As high-performance memory devices achieve fast operating speeds, higher signal quality and reliability are desired for data exchanged between an application processor and a memory device (e.g., a DRAM device). To ensure data reliability, optimizing the clock timing of data or signals transmitted through an interface is important, and training may be conducted to achieve a desired level of data reliability.

### SUMMARY

The present disclosure relates to a memory device.

In some cases, chip select signal training may be used to optimize a chip select signal and a clock signal transmitted between a host and a memory device. However, when a region in which a sampling fail is detected during a sampling process of the chip select signal is too narrow, the sampling fail may be skipped without being detected. Implementations of the present disclosure provide a memory device capable of efficiently performing chip select signal training by expanding a region in which a sampling fail is detected.

An aspect of the present disclosure provides a memory device that may include a clock divider configured to receive a clock signal from a host, divide the clock signal, and generate at least two internal clock signals; an internal clock selector configured to receive the at least two internal clock signals from the clock divider and select one of the at least two internal clock signals as a target internal clock signal; and a sampler configured to receive a chip select signal from the host, receive the target internal clock signal from the internal clock selector, and sample the chip select signal using the target internal clock signal.

Another aspect of the present disclosure provides a method of operating a memory device. The method may include dividing, during a training mode with respect to a chip select signal, a clock signal to generate at least two internal clock signals; selecting one of the at least two internal clock signals as a target internal clock signal; sampling the chip select signal using the target internal clock signal; and adjusting a delay time to be applied to the chip select signal based on a result of sampling the chip select signal.

Yet another aspect of the present disclosure provides a memory system that may include a memory device; and a host configured to provide a clock signal and a chip select signal to the memory device during a training with respect to a chip select signal. The memory device may include a clock divider configured to divide the clock signal received from the host and generate at least two internal clock signals; an internal clock selector configured to receive the at least two internal clock signals from the clock divider and select one of the at least two internal clock signals as a target internal clock signal; and a sampler configured to receive the chip select signal from the host, receive the target internal clock signal from the internal clock selector, and sample the chip select signal using the target internal clock signal.

According to the memory device of the present disclosure, a region in which a sampling fail is detected expands, and thus chip select signal training is efficiently performed.

At least some of the above and other features of the invention are set out in the claims.

### BRIEF DESCRIPTION OF THE DRAWINGS

The above and other objects and features of the present disclosure will become apparent by describing in detail implementations thereof with reference to the accompanying drawings.
FIG. 1 is a block diagram schematically illustrating an example memory system according to an implementation of the present disclosure.
FIGS. 2A, 2B, 2C, and 2D are diagrams illustrating a sampling operation and a fail detection region in which a sampling fail is detected during a CS training operation according to an example implementation of the present disclosure.
FIGS. 3A, 3B, 3C, and 3D are diagrams illustrating a sampling operation and a fail detection region in which a sampling fail is detected during a CS training operation according to a comparative example.
FIG. 4 is a flowchart illustrating an example operation of performing a CS training according to an implementation of the present disclosure.
FIG. 5 is a block diagram schematically illustrating an example memory system according to an implementation of the present disclosure.
FIG. 6 is a block diagram illustrating an example training circuit according to an implementation of the present disclosure.
FIG. 7 is a block diagram illustrating an example sampling circuit according to an implementation of the present disclosure.
FIG. 8 is a diagram illustrating an example operation in which the sampling circuit of FIG. 7 determines an even internal clock signal.
FIG. 9A is a diagram illustrating an example CS training operation according to an implementation of the present disclosure.
FIG. 9B is a diagram illustrating a CS training operation according to a comparative example.
FIG. 10 is a flowchart illustrating an example operation of performing a CS training according to an implementation of the present disclosure.
FIG. 11 is a block diagram schematically illustrating an example memory system according to an implementation of the present disclosure.
FIG. 12 is a diagram illustrating an example CS training operation according to an implementation of the present disclosure.
FIG. 13 is a flowchart illustrating an example operation of performing a CS training according to an implementation of the present disclosure.
FIG. 14 is a block diagram schematically illustrating an example memory system according to an implementation of the present disclosure.
FIG. 15 is a block diagram illustrating an example memory device according to an implementation of the present disclosure.

### DETAILED DESCRIPTION

Below, implementations of the present disclosure will be described in detail and clearly to such an extent that an ordinary one in the art easily implements the disclosure.

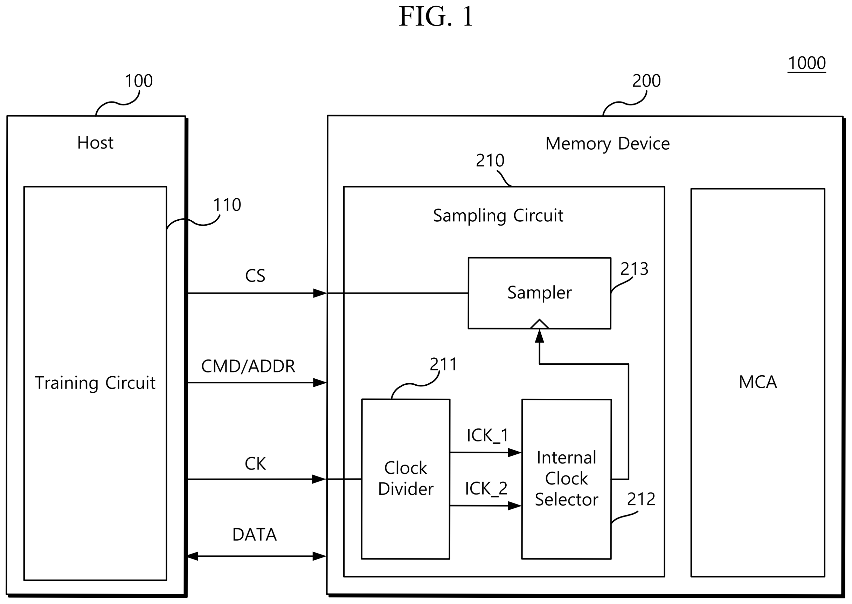

FIG. 1 is a block diagram schematically illustrating a memory system 1000 according to an implementation of the present disclosure.

Chip select signal training (hereinafter, referred to as CS training) according to an implementation of the present disclosure may divide a clock signal into at least two internal clock signals and may perform a sampling operation on a chip select signal using one of the at least two internal clock signals. Accordingly, a region in which a sampling fail (also referred to herein as sampling failure) is detected may be expanded, and as a result, the CS training may be efficiently performed.

Referring to FIG. 1 in more detail, the memory system 1000 may include a host 100 and a memory device 200.

The host 100 may perform an access operation of writing data DATA to the memory device 200 or reading data DATA stored in the memory device 200. The host 100 may generate the clock signal CK, the chip select signal CS, a command CMD, and/or an address ADDR to write the data DATA to the memory device 200 or to read the data DATA stored in the memory device 200. For example, the host 100 may be at least one of a chipset to control the memory device 200, a system on chip (SoC) such as a mobile application processor (AP) (hereinafter, referred to as an AP), a CPU, a GPU, or test devices.

The host 100 may perform a CS training on the memory device 200 under specific conditions, such as booting or initialization of the memory device 200. For example, the host 100 may include a training circuit 110.

The training circuit 110 may perform the CS training on the memory device 200. In the present implementation, the CS training may refer to training to align a center of the chip select signal CS provided from the host 100 to the memory device 200 with a rising edge or a falling edge of the clock signal CK. The host 100 may normally transmit the command CMD and/or the address ADDR to the memory device 200 through the CS training.

When performing the CS training, the training circuit 110 may provide the clock signal CK together with the chip select signal CS to the memory device 200. Then, the chip select signal CS may be sampled by an internal clock signal divided from the clock signal CK in the memory device 200, and the training circuit 110 may receive a corresponding sampling result from the memory device 200. Based on the sampling result, the training circuit 110 may adjust a delay time applied to the chip select signal CS. For example, the training circuit 110 may push the chip select signal CS or pull the chip select signal CS to align the center of the chip select signal CS with the rising edge or the falling edge of the internal clock signal.

The memory device 200 may perform a read operation or a write operation under the control of the host 100. For example, during the read operation, the memory device 200 may receive the clock signal CK, the command CMD requesting the read operation, and the address ADDR from the host 100. The memory device 200 may read out the requested data DATA and may transmit the read-out data to the host 100. For example, during the write operation, the memory device 200 may receive the data DATA, the clock signal CK, the command CMD requesting the write operation, and the address ADDR from the host 100. The memory device 200 may store the data DATA in a requested location.

The memory device 200 may include a memory cell array MCA storing data. For example, the memory cell array MCA of the memory device 200 may be implemented to include a volatile memory, such as a dynamic random access memory (DRAM), a static random access memory (SRAM), and the like. For example, the memory cell array MCA of the memory device 200 may be implemented to include a non-volatile memory, such as an electrically erasable programmable read-only memory (EEPROM), a flash memory, a magnetic RAM (MRAM), a phase change RAM (PRAM), a resistive RAM (RRAM), and the like. For example, a part of the memory cell array MCA of the memory device 200 may be implemented to include a volatile memory, and another part of the memory cell array MCA may be implemented to include a non-volatile memory. In the present disclosure, it is assumed that the memory cell array MCA of the memory device 200 is a DRAM chip including a DRAM.

When performing the CS training, the memory device 200 may receive the chip select signal CS and the clock signal CK from the host 100. The memory device 200 may perform the sampling operation on the chip select signal CS based on the clock signal CK.

In particular, when performing the CS training according to an implementation of the present disclosure, the memory device 200 may divide the clock signal CK to generate at least two internal clock signals and may perform the sampling operation on the chip select signal CS using one of the at least two internal clock signals. For example, the memory device 200 may include a sampling circuit 210, and the sampling circuit 210 may include a clock divider 211, an internal clock selector 212, and a sampler 213.

The clock divider 211 may receive the clock signal CK from the training circuit 110 and may divide the clock signal CK to generate the at least two internal clock signals. For example, the clock divider 211 may divide the clock signal CK by 2 to generate a first internal clock signal ICK_1 and a second internal clock signal ICK_2. However, this is merely an example. In other implementations, the clock divider 211 may divide the clock signal CK by 2N (where N is a natural number). As an example, the clock divider 211 may divide the clock signal CK by 4 to generate four internal clock signals or may divide the clock signal CK by 8 to generate eight internal clock signals.

The internal clock selector 212 may receive the at least two internal clock signals from the clock divider 211 and may select one of the internal clock signals as a signal to sample the chip select signal CS. For example, the internal clock selector 212 may receive the first internal clock signal ICK_1 and the second internal clock signal ICK 2 and may select one of the first and second internal clock signals ICK_1 and ICK 2 as a signal to sample the chip select signal CS.

In an implementation, the internal clock selector 212 may receive the first internal clock signal ICK_1 and the second internal clock signal ICK_2 and may select one of the first and second internal clock signals ICK_1 and ICK 2 as a signal to sample a high level of the chip select signal CS. In this case, the selected internal clock signal may be provided to the sampler 213, and the unselected internal clock signal may not be provided to the sampler 213.

In an implementation, the internal clock selector 212 may receive the first internal clock signal ICK_1 and the second internal clock signal ICK 2 and may select one of the first and second internal clock signals ICK_1 and ICK 2 as a signal to sample a low level of the chip select signal CS. In this case, the selected internal clock signal may be provided to the sampler 213, and the unselected internal clock signal may not be provided to the sampler 213.

In an implementation, the internal clock selector 212 may receive the first internal clock signal ICK_1 and the second internal clock signal ICK 2 and may select one of the first and second internal clock signals ICK_1 and ICK 2 as the signal to sample the high level of the chip select signal CS and may select the other internal clock signal as the signal to sample the low level of the chip select signal CS. In this case, the sampler 213 may include a first sampler and a second sampler, and the internal clock signal selected to sample the high level may be provided to the first sampler, and the internal clock signal selected to sample the low level may be provided to the second sampler.

The sampler 213 may receive the chip select signal CS from the training circuit 110 and may receive the internal clock signal from the internal clock selector 212. The sampler 213 may perform the sampling operation on the chip select signal CS based on the internal clock signal. The sampling result obtained by the sampler 213 may be transmitted to the training circuit 110.

As described above, during the CS training according to the implementation of the present disclosure, the memory device 200 may divide the clock signal into the at least two internal clock signals and may perform the sampling operation on the chip select signal using one of the at least two internal clock signals. Accordingly, the region where the sampling fail is detected may be expanded, and as a result, the CS training may be performed efficiently.

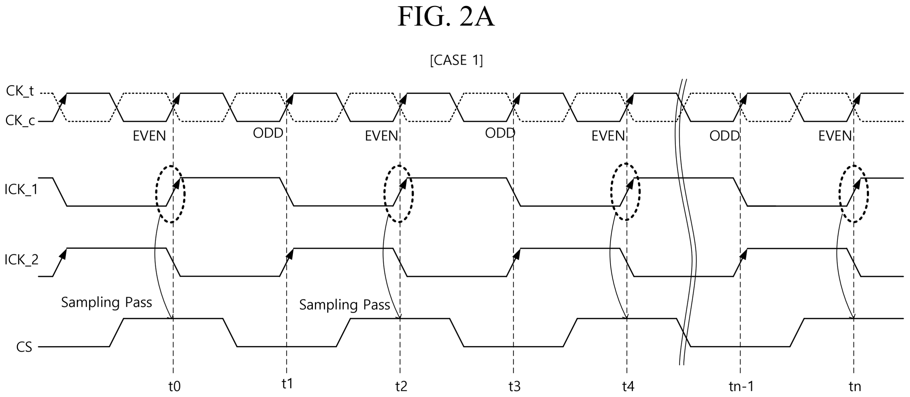

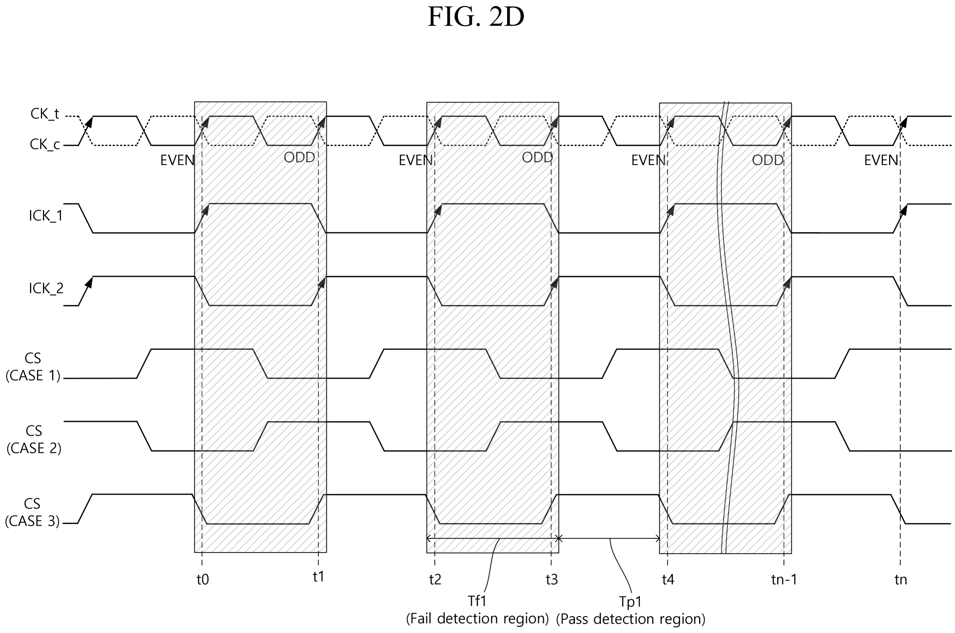

FIGS. 2A to 2D are diagrams illustrating the sampling operation and a fail detection region in which the sampling fail is detected during the CS training operation according to an implementation of the present disclosure. In detail, FIGS. 2A to 2C illustrate sampling operations of the present disclosure for chip select signals CS having different delay times as a representative example. FIG. 2D illustrates the fail detection region of the present disclosure.

For convenience of explanation, in FIGS. 2A to 2D, it is assumed that the clock signal is divided into two internal clock signals ICK_1 and ICK_2, and the high level of the chip select signal CS is sampled using the rising edge of the first internal clock signal ICK_1 of the two internal clock signals ICK_1 and ICK_2.

Referring to FIGS. 1 and 2A to 2D, the clock divider 211 may receive differential clock signals CK_t and CK_c as the clock signal CK. The clock divider 211 may divide the differential clock signals CK_t and CK_c by two (2) and thereby generate the first internal clock signal ICK_1 and the second internal clock signal ICK_2. In this case, a frequency of each of the first internal clock signal ICK_1 and the second internal clock signal ICK_2 may be one-half (1/2) of the frequency of the differential clock signals CK_t and CK_c.

The internal clock selector 212 may select the first internal clock signal ICK_1 from the first internal clock signal ICK_1 and the second internal clock signal ICK 2 as the signal to sample the high level of the chip select signal CS.

The sampler 213 may receive the chip select signal CS and the first internal clock signal ICK_1. The sampler 213 may sample the chip select signal CS at the rising edge of the first internal clock signal ICK_1. In this case, when the chip select signal CS is at a high level at the rising edge of the first internal clock signal ICK_1, the sampling result may be 'pass' (i.e., successful sampling or sampling success). When the chip select signal CS is at a low level or in an indeterminate region at the rising edge of the first internal clock signal ICK_1, the sampling result may be 'fail' (i.e., sampling failure).

As an example, referring to a first case CASE 1 of FIG. 2A, the rising edges of the first internal clock signal ICK_1 correspond to 0-th, 2nd, 4th, and n-th time points t0, t2, t4, and tn. The chip select signal CS is at a high level at the 0-th, 2nd, 4th, and n-th time points t0, t2, t4, and tn. Accordingly, the sampling results in the first case may all be 'pass'.

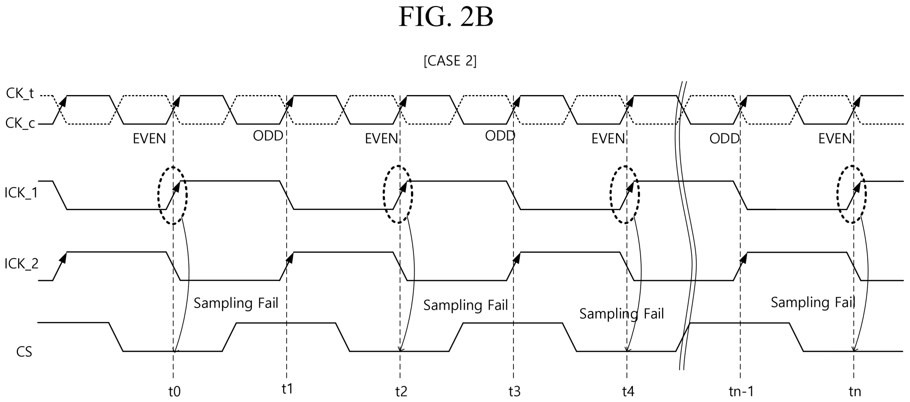

As an example, referring to a second case CASE 2 of FIG. 2B, the delay time of the chip select signal CS differs from that of the chip select signal CS in FIG. 2A. At 0-th, 2nd, 4th, and n-th time points t0, t2, t4, and tn, which correspond to the rising edges of the first internal clock signal ICK_1, the chip select signal CS is at a low level. Accordingly, the sampling results in the second case may all be 'fail'.

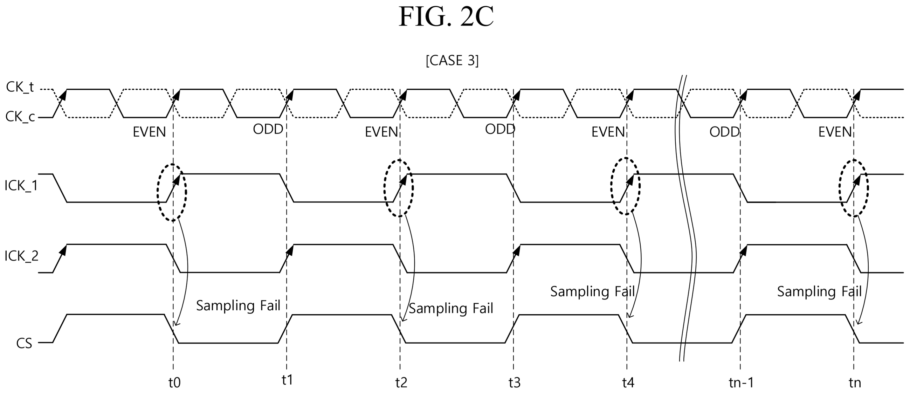

As an example, referring to a third case CASE 3 of FIG. 2C, the delay time applied to the chip select signal CS differs from the delay times applied to the chip select signals CS in FIGS. 2A and 2B. At 0-th, 2nd, 4th, and n-th time points t0, t2, t4, and tn, which correspond to the rising edges of the first internal clock signal ICK_1, the chip select signal CS transitions from a high level to a low level. That is, the 0-th, 2nd, 4th, and n-th time points t0, t2, t4, and tn, which correspond to the rising edges of the first internal clock signal ICK_1, correspond to the indeterminate region in which it is difficult to determine the sampling result. Accordingly, the sampling results in the third case may all be 'fail'.

As described in the first to third cases of FIGS. 2A to 2C, the sampling operations of the present disclosure may output 'fail' as the sampling result not only when the rising edge of the first internal clock signal ICK_1 corresponds to the indeterminate region of the chip select signal CS, but also when the rising edge of the first internal clock signal ICK_1 corresponds to the low level of the chip select signal CS.

Accordingly, as illustrated in FIG. 2D, the fail detection region may have a time interval corresponding to 'Tf1'. Here, the fail detection region may refer to a region in which 'fail' is output as the sampling result when sampling the chip select signal CS using the internal clock signal, i.e., the first internal clock signal ICK_1, used for the sampling operation. For example, 'Tf1" may be a time interval corresponding to 2tCK.

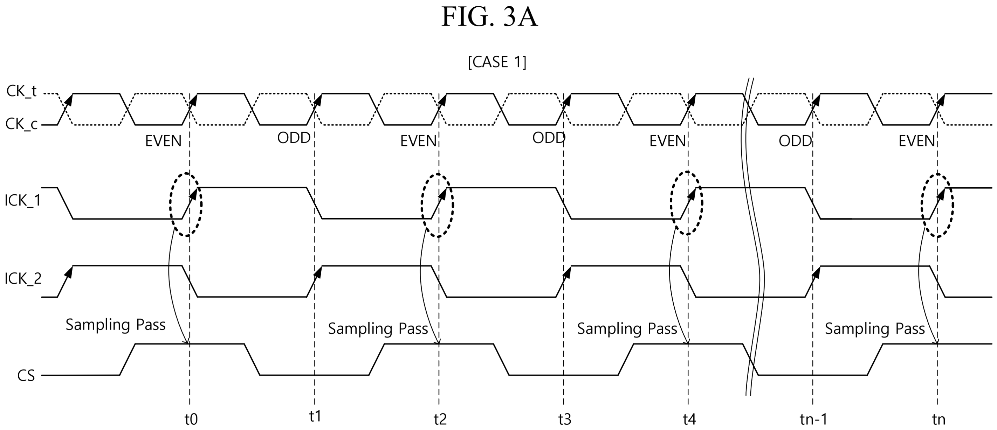

In addition, as illustrated in FIG. 2D, a pass detection region may have a time interval corresponding to 'Tp1'. Here, the pass detection region may refer to a region in which 'pass' is output as the sampling result when sampling the chip select signal CS using the internal clock signal, i.e., the first internal clock signal ICK_1, used for the sampling operation. As will be described below with reference to FIGS. 3A to 3D, the fail detection region may be larger than a fail detection region of a comparative example.

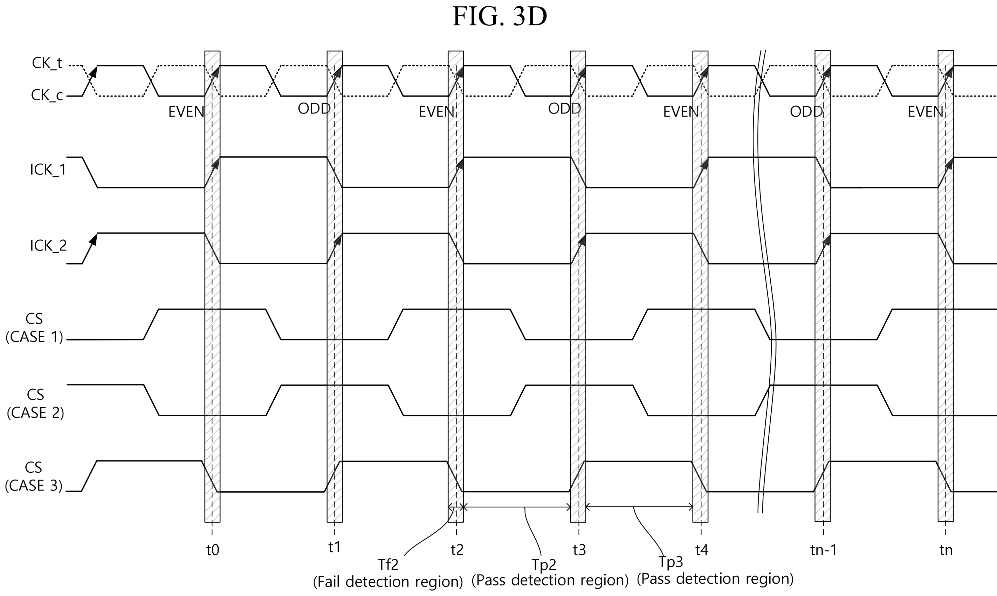

FIGS. 3A to 3D are diagrams illustrating a sampling operation and a fail detection region in which a sampling fail is detected during a CS training operation according to a comparative example. In detail, FIGS. 3A to 3C illustrate sampling operations of the comparative example for chip select signals CS having different delay times as a representative example. FIG. 3D illustrates the fail detection region of the comparative example.

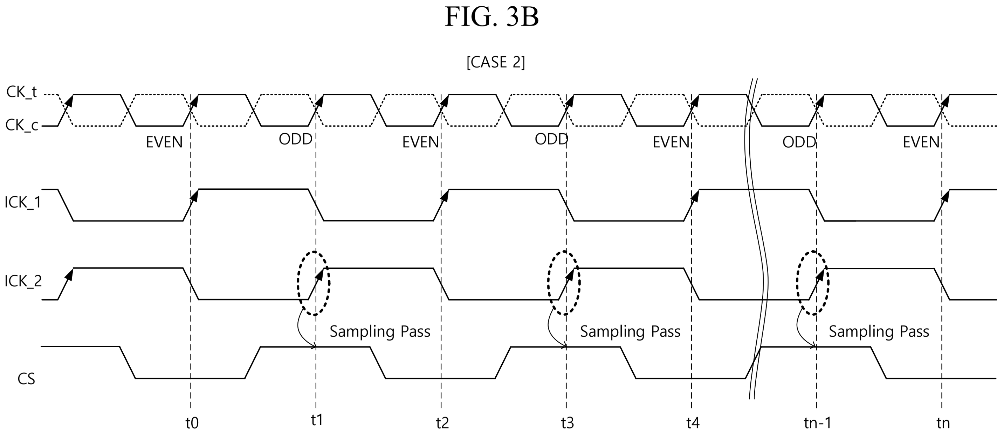

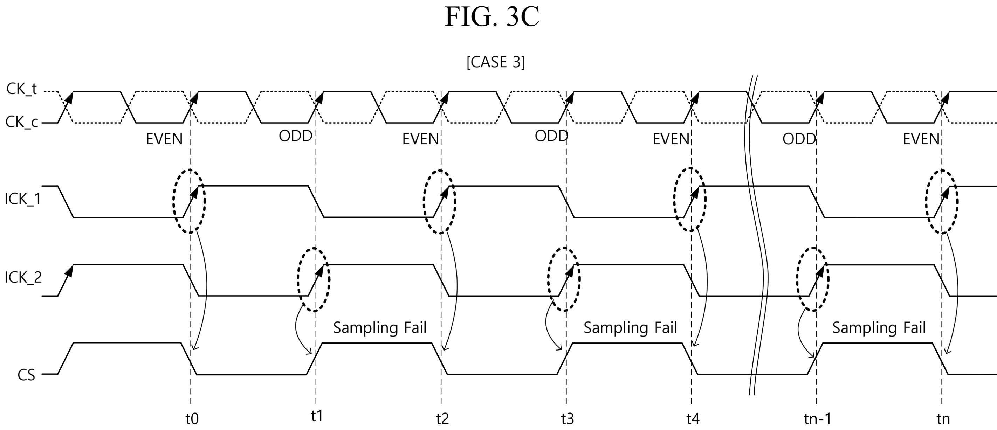

For convenience of explanation, in the same manner as FIGS. 2A to 2D, it is assumed that a clock signal is divided into two internal clock signals ICK_1 and ICK_2. In addition, it is assumed that the delay time of the chip select signal CS in FIG. 3A is the same as the delay time of the chip select signal CS in FIG. 2A, the delay time of the chip select signal CS in FIG. 3B is the same as that of the chip select signal CS in FIG. 2B, and the delay time of the chip select signal CS in FIG. 3C is the same as that of the chip select signal CS in FIG. 2C. However, unlike in FIGS. 2A to 2D, in the comparative example, it is assumed that a high level of the chip select signal CS is sampled not only using a rising edge of a first internal clock signal ICK_1, but also using a rising edge of a second internal clock signal ICK_2.

First, referring to a first case CASE 1 of FIG. 3A, the rising edges of the first internal clock signal ICK_1 correspond to 0-th, 2nd, 4th, and n-th time points t0, t2, t4, and tn. The chip select signal CS is at a high level at the 0-th, 2nd, 4th, and n-th time points t0, t2, t4, and tn. Accordingly, the sampling results in the first case may all be 'pass'.

Referring to a second case CASE 2 of FIG. 3B, the chip select signal CS is at a high level at 1st, 3rd, and (n-1)th time points t1, t3, and tn-1, which correspond to the rising edges of the second internal clock signal ICK_2. Accordingly, the sampling results in the second case may all be 'pass'.

Referring to a third case CASE 3 of FIG. 3C, at the 0-th, 2nd, 4th, and n-th time points t0, t2, t4, and tn, which correspond to the rising edges of the first internal clock signal ICK_1, the chip select signal CS transitions from a high level to a low level. In addition, at the 1st, 3rd, and (n-1)-th time points t1, t3, and tn-1, which correspond to the rising edges of the second internal clock signal ICK_2, the chip select signal CS transitions from a low level to a high level. That is, all of the 0-th, 2nd, 4th, and n-th time points t0, t2, t4, tn corresponding to the rising edges of the first internal clock signal ICK_1 and the 1st, 3rd, and (n-1)-th time points t1, t3, and tn-1 corresponding to the rising edges of the second internal clock signal ICK_2 may correspond to indeterminate regions. Accordingly, the sampling results in the third case may all be 'fail'.

As described in the cases of FIGS. 3A to 3C, the sampling operations of the comparative example output 'fail' as the sampling result only in the third case in which both the rising edge of the first internal clock signal ICK_1 and the rising edge of the second internal clock signal ICK 2 correspond to the indeterminate region.

Accordingly, as illustrated in FIG. 3D, the fail detection region of the comparative example may have a time interval corresponding to 'Tf2'. This may be a very short time compared to 'Tf1', which is the fail detection region of the implementation of the present disclosure illustrated in FIG. 2D.

In addition, as illustrated in FIG. 3D, a pass detection region of the comparative example may have a time interval corresponding to 'Tp2 + Tp3'. This may be a very long time compared to 'Tp1', which is the pass detection region of the implementation of the present disclosure shown in FIG. 2D.

In the case where the fail detection region is short as in the comparative example, the CS training may not be effectively performed. In particular, when the delay time applied to the chip select signal CS is longer than the fail detection region, the fail detection region may not be detected and may be skipped. Therefore, in the case of the comparative example, to prevent the fail detection region from being skipped, the delay time applied to the chip select signal CS is required be set to a very short interval, and thus, the time required to perform the CS training may increase.

In contrast, as illustrated in FIGS. 2A to 2D, the CS training according to implementations of the present disclosure may divide the clock signals CK_t and CK_c into the two internal clock signals ICK_1 and ICK_2 and may perform the sampling operation on the chip select signal CS using the first internal clock signal ICK_1. Accordingly, the region in which the sampling fail is detected may be expanded, and as a result, the CS training may be efficiently performed.

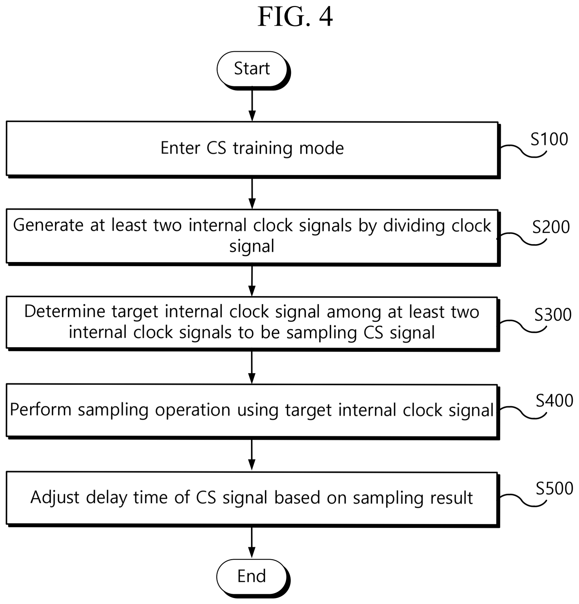

FIG. 4 is a flowchart illustrating the operation of performing the CS training according to an implementation of the present disclosure.

The memory system 1000 (refer to FIG. 1) may enter a CS training mode in operation S100.

For example, the memory system 1000 (refer to FIG. 1) may enter the CS training mode under specific conditions such as booting or initialization.

In operation S200, the clock signal may be divided to generate the at least two internal clock signals.

For example, the clock divider 211 (refer to FIG. 1) may divide the clock signal CK by two (2) to generate the two internal clock signals ICK_1 and ICK_2. In this case, the frequency of each of the two internal clock signals ICK_1 and ICK_2 may be one-half (1/2) of the frequency of the clock signal CK.

In operation S300, a target internal clock signal, which is used to sample the high level of the chip select signal, may be selected from the at least two internal clock signals.

For example, the internal clock selector 212 (refer to FIG. 1) may select the first internal clock signal ICK_1 as the target internal clock signal to sample the high level of the chip select signal CS from the two internal clock signals ICK_1 and ICK_2.

In operation S400, the sampling operation may be performed using the target internal clock signal.

For example, the sampler 213 (refer to FIG. 1) may sample the chip select signal CS at the rising edge of the first internal clock signal ICK_1. When the chip select signal CS is at the high level at the rising edge of the first internal clock signal ICK_1, the sampling result may be 'pass'. When the chip select signal CS is at the low level or in the indeterminate region at the rising edge of the first internal clock signal ICK_1, the sampling result may be 'fail'.

In operation S500, the delay time of the chip select signal may be adjusted based on the sampling result.

For example, the training circuit 110 (refer to FIG. 1) may adjust the delay time of the chip select signal CS based on the sampling result of the sampler 213. For example, the training circuit 110 may push the chip select signal CS or pull the chip select signal CS to align the center of the chip select signal CS with the rising edge of the first internal clock signal ICK_1.

As described above, the CS training operation according to implementations of the present disclosure may divide the clock signal into the at least two internal clock signals and may perform the sampling operation on the chip select signal using one of the at least two internal clock signals. Accordingly, the region in which the sampling fail is detected may be expanded, and as a result, the CS training may be efficiently performed.

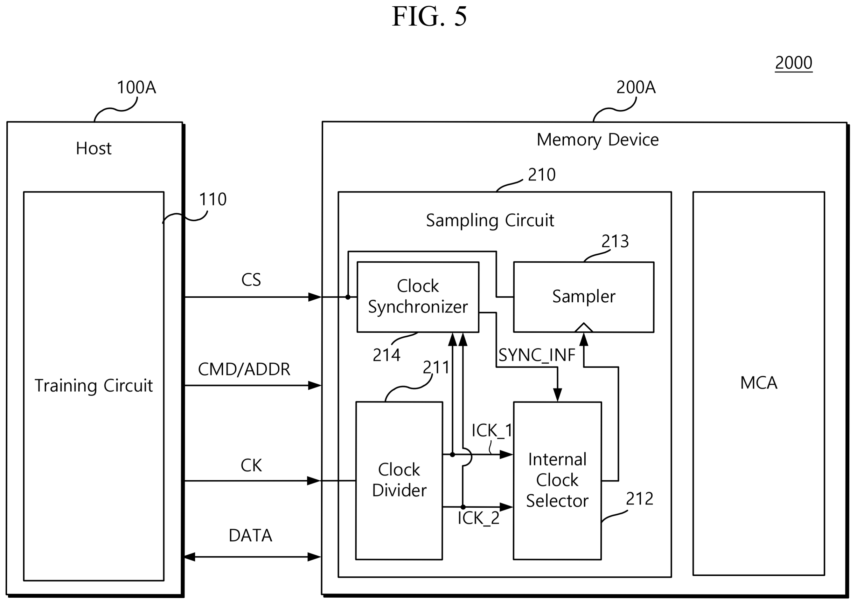

FIG. 5 is a block diagram schematically illustrating a memory system 2000 according to an implementation of the present disclosure. The memory system 2000 of FIG. 5 is similar to the memory system 1000 of FIG. 1. Accordingly, in FIG. 5, the same or similar reference numerals denote the same or similar elements in FIG. 1, and thus detailed descriptions of the same or similar elements will be omitted.

Referring to FIG. 5, the memory system 2000 may include a host 100A and a memory device 200A. The host 100A may include a training circuit 110, and the memory device 200A may include a sampling circuit 210 and a memory cell array MCA. The sampling circuit 210 may include a clock divider 211, an internal clock selector 212, a sampler 213, and a clock synchronizer 214.

The clock synchronizer 214 may receive a chip select signal CS from the training circuit 110 and may receive at least two internal clock signals from the clock divider 211. The clock synchronizer 214 may determine an even edge among edges of the at least two internal clock signals based on the chip select signal CS. In other words, the clock synchronizer 214 may classify the edges of the at least two internal clock signals into even edges and odd edges based on synchronization information between the chip select signal CS and the internal clock signal.

As an example, the even edge may be defined as an edge serving as a reference to transmit a command CMD. For example, it may be predetermined that the command CMD is transmitted from the host 100A to the memory device 200A only at the even edge. In this case, it may be predetermined that a command transmitted at the odd edge is an invalid command.

In an implementation, the clock synchronizer 214 may determine the even edge among the edges of the at least two internal clock signals based on synchronization information between the chip select signal CS and the at least two internal clock signals.

For example, the clock synchronizer 214 may determine the even edge based on an alignment between rising edges of first and second internal clock signals ICK_1 and ICK 2 and a high level of the chip select signal CS. That is, the clock synchronizer 214 may determine the rising edge aligned with the high level of the chip select signal CS among the rising edges of the first and second internal clock signals ICK_1 and ICK_2 as the even edge. When the first internal clock signal ICK_1 of the first and second internal clock signals ICK_1 and ICK 2 is aligned with the high level of the chip select signal CS consecutively for a predetermined number of times, the clock synchronizer 214 may determine the rising edge of the first internal clock signal ICK_1 as the even edge. However, this is merely an example, and the present disclosure is not limited thereto or thereby.

According to an implementation, the clock synchronizer 214 may determine the even edge based on an alignment between falling edges of the first and second internal clock signals ICK_1 and ICK_2 and the high level of the chip select signal CS. That is, the clock synchronizer 214 may determine a falling edge, which is aligned with the high level of the chip select signal CS, among the falling edges of the first and second internal clock signals ICK_1 and ICK 2 as the even edge.

According to an implementation, the clock synchronizer 214 may determine the even edge based on an alignment between the rising edges of the first and second internal clock signals ICK_1 and ICK 2 and a low level of the chip select signal CS.

According to an implementation, the clock synchronizer 214 may determine the even edge based on an alignment between the falling edges of the first and second internal clock signals ICK_1 and ICK 2 and the low level of the chip select signal CS.

The clock synchronizer 214 may provide the synchronization information SYNC_INF with respect to the even edge to the internal clock selector 212.

The internal clock selector 212 may receive the synchronization information SYNC_INF with respect to the even edge from the clock synchronizer 214. Based on the synchronization information SYNC_INF with respect to the even edge, the internal clock selector 212 may identify the internal clock signal having the even edge, from the first internal clock signal ICK_1 and the second internal clock signal ICK 2 and may determine the identified internal clock signal as an even internal clock signal. In this case, the internal clock selector 212 may determine the internal clock signal that does not have the even edge as an odd internal clock signal.

In an implementation, the internal clock selector 212 may select the even internal clock signal from the first internal clock signal ICK_1 and the second internal clock signal ICK 2 as the signal to sample the high level of the chip select signal CS.

In an implementation, the internal clock selector 212 may select the even internal clock signal from the first internal clock signal ICK_1 and the second internal clock signal ICK_2 as the signal to sample the low level of the chip select signal CS.

In an implementation, the internal clock selector 212 may select the even internal clock signal from the first internal clock signal ICK_1 and the second internal clock signal ICK_2 as the signal to sample the high level of the chip select signal CS and may select the odd internal clock signal as the signal to sample the low level of the chip select signal CS.

As described above, the sampling circuit 210 may include the clock synchronizer 214, and the clock synchronizer 214 may provide the synchronization information SYNC_INF with respect to the even edge to the internal clock selector 212. The internal clock selector 212 may determine, based on the synchronization information SYNC_INF with respect to the even edge, the internal clock signal to sample the chip select signal CS from the first internal clock signal ICK_1 and the second internal clock signal ICK_2. Accordingly, during the CS training, the region in which a sampling fail is detected may be expanded, and as a result, the CS training may be efficiently performed.

In FIG. 5, it is described that the even edge is defined as the edge serving as the reference to transmit the command CMD. However, this is merely an example, and the present disclosure is not limited thereto or thereby. According to an implementation, it may be predetermined that the command CMD is transmitted from the host 100A to the memory device 200A only at the odd edge. In this case, the clock synchronizer 214 may determine the odd edge among the edges of the at least two internal clock signals based on the chip select signal CS. In this case, the odd internal clock signal including the odd edge may be selected as the internal clock signal to select the high level of the chip select signal CS.

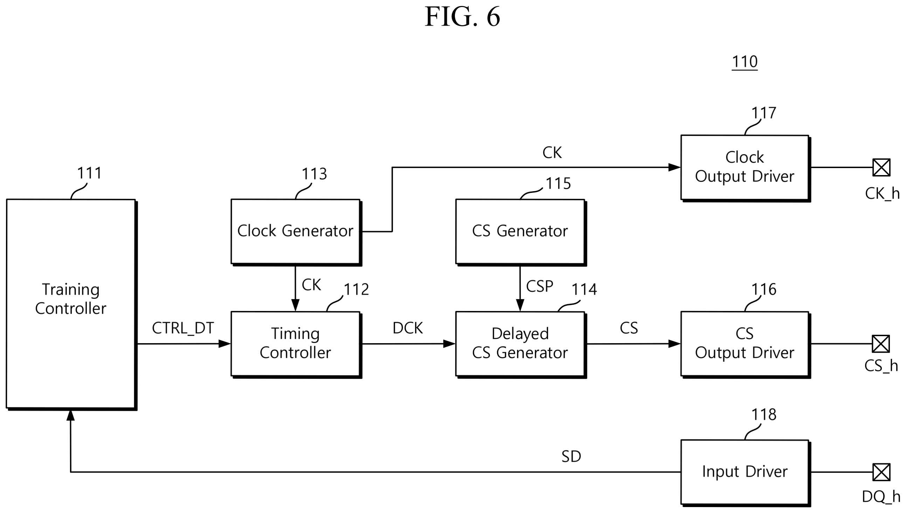

FIG. 6 is a block diagram illustrating the training circuit 110 according to an implementation of the present disclosure in more detail. The training circuit 110 of FIG. 6 may correspond to the training circuit 110 of FIG. 5.

During the CS training, the training circuit 110 may provide the chip select signal CS and the clock signal CK to the memory device 200A (refer to FIG. 5). Further, during the CS training, the memory device 200A may provide sampling data SD, including the sampling result, to the training circuit 110.

When the chip select signal CS is successfully sampled by the memory device 200A, the command/address CMD/ADDR may be normally transmitted to the memory device 200.

On the other hand, when the chip select signal CS is not successfully sampled by the memory device 200A, the command/address CMD/ADDR may not be normally transmitted to the memory device 200A.

Referring to FIG. 6, the training circuit 110 may include a training controller 111, a timing controller 112, a clock generator 113, a delayed chip select signal generator 114, a chip select signal generator 115, a chip select signal output driver 116, a clock output driver 117, and an input driver 118. Hereinafter, the delayed chip select signal generator 114 will be referred to as a delayed CS generator 114, the chip select signal generator 115 will be referred to as a CS generator 115, and the chip select signal output driver 116 will be referred to as a CS output driver 116.

The training controller 111 may receive the sampling data SD from the memory device 200A and may determine the sampling result. Based on the sampling result, the training controller 111 may set a delay time to be applied to the chip select signal CS.

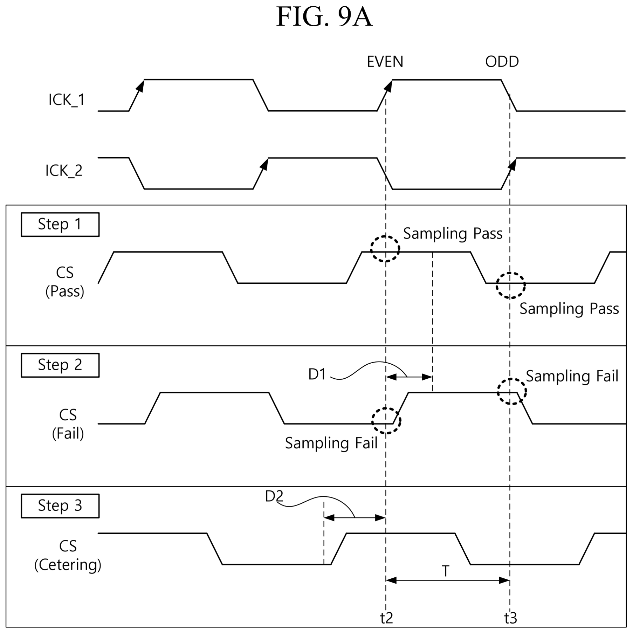

For example, when the sampling result is 'pass', the training controller 111 may set the delay time to be applied to the chip select signal CS such that the chip select signal CS is pushed. In this case, the chip select signal CS may be pushed by a first delay time based on a sampling pass point. This will be described in more detail with reference to a first step and a second step of FIG. 9A below. However, this is merely an example, and according to an implementation, the chip select signal CS may be pulled by the first delay time based on the sampling pass point.

For example, when the sampling result is 'fail', the training controller 111 may set the delay time to be applied to the chip select signal CS such that the edge of the internal clock signal is aligned with a center of the high level of the chip select signal CS. In this case, the chip select signal CS may be pulled by a second delay time based on a sampling fail point. The second delay time may be set based on a period of the internal clock signal. This will be described in more detail with reference to the second step and a third step of FIG. 9A below. However, this is merely an example, and according to an implementation, the chip select signal CS may be pushed by the second delay time based on the sampling fail point.

The training controller 111 may provide a delay control signal CTRL_DT including information on the delay time to the timing controller 112.

The timing controller 112 may receive the delay control signal CTRL_DT from the training controller 111 and may receive the clock signal CK from the clock generator 113. The timing controller 112 may generate a delay clock signal DCK in response to the delay control signal CTRL_DT.

The clock generator 113 may generate the clock signal CK. The clock generator 113 may provide the clock signal CK to each of the timing controller 112 and the clock output driver 117.

The delayed CS generator 114 may receive the delay clock signal DCK from the timing controller 112 and may receive a chip select signal pattern CSP from the CS generator 115. The delayed CS generator 114 may synchronize the chip select signal pattern CSP with the delay clock signal DCK to generate the chip select signal CS.

The CS generator 115 may generate the chip select signal pattern CSP to generate the chip select signal CS.

The CS output driver 116 may receive the chip select signal CS from the delayed CS generator 114 and may provide the chip select signal CS to the memory device 200A via a host CS pad CS_h.

The clock output driver 117 may receive the clock signal CK from the clock generator 113 and may provide the clock signal CK to the memory device 200A via a host clock pad CK_h.

The input driver 118 may receive the sampling data SD from the memory device 200A via a host data pad DQ_h and may provide the sampling data SD to the training controller 111.

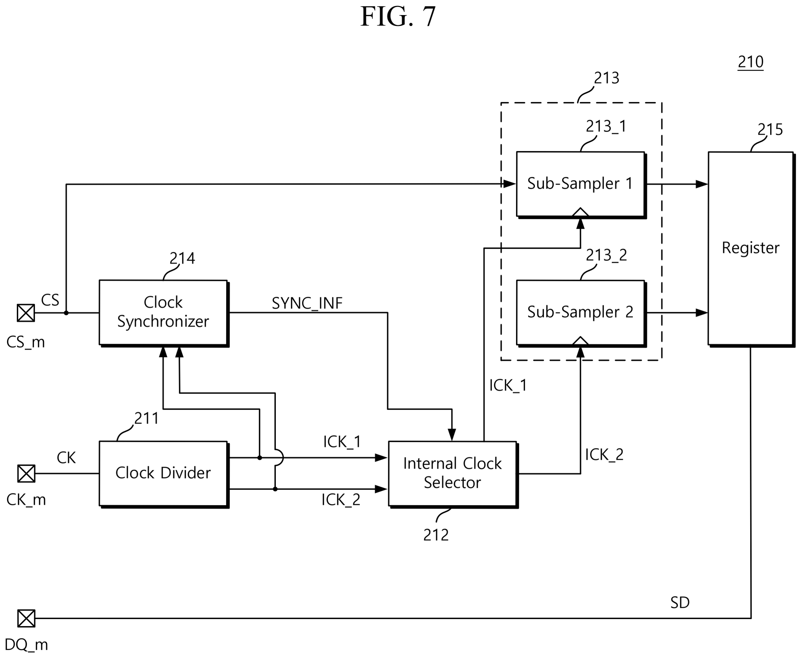

FIG. 7 is a block diagram illustrating the sampling circuit 210 according to an implementation of the present disclosure in more detail. The sampling circuit 210 of FIG. 7 may correspond to the sampling circuit 210 of FIG. 5. As an example, FIG. 7 illustrates the implementation in which the first internal clock signal ICK_1 and the second internal clock signal ICK_2 are selected as the even internal clock signal and the odd internal clock signal, respectively, and the even internal clock signal and the odd internal clock signal are used to sample the high level and the low level of the chip select signal CS, respectively.

Referring to FIG. 7, the sampling circuit 210 may include the clock divider 211, the internal clock selector 212, the sampler 213, the clock synchronizer 214, and a register 215.

The clock divider 211 may receive the clock signal CK from the training circuit 110 (refer to FIG. 6) through a memory clock pad CK_m. The clock divider 211 may divide the clock signal CK to generate the first internal clock signal ICK_1 and the second internal clock signal ICK_2.

The clock synchronizer 214 may receive the chip select signal CS from the training circuit 110 through a memory CS pad CS_m and may receive the first internal clock signal ICK_1 and the second internal clock signal ICK_2 from the clock divider 211. The clock synchronizer 214 may determine the even edge among the edges of the first and second internal clock signals ICK_1 and ICK 2 based on the alignment between the rising edges of the first and second internal clock signals and the high level of the chip select signal CS. The clock synchronizer 214 may provide the synchronization information SYNC_INF, which includes information on the even edge, to the internal clock selector 212.

The internal clock selector 212 may receive the synchronization information SYNC_INF, which includes the information on the even edge, from the clock synchronizer 214. Based on the synchronization information SYNC_INF, the internal clock selector 212 may identify the internal clock signal having the even edge from the first internal clock signal ICK_1 and the second internal clock signal ICK 2 and may determine the identified internal clock signal as the even internal clock signal.

For example, the internal clock selector 212 may determine the first internal clock signal ICK_1 as the even internal clock signal to sample the high level of the chip select signal CS. In addition, the internal clock selector 212 may determine the second internal clock signal ICK_2 as the odd internal clock signal to sample the low level of the chip select signal CS.

The sampler 213 may include a first sub-sampler 213_1 and a second sub sampler 213_2.

The first sub-sampler 213_1 may receive the chip select signal CS from the training circuit 110 and may receive the first internal clock signal ICK_1 from the internal clock selector 212. The first sub-sampler 213_1 may perform the sampling operation on the high level of the chip select signal CS based on the first internal clock signal ICK_1.

For example, when the chip select signal CS is at a high level at the rising edge of the first internal clock signal ICK_1, the first sub-sampler 213_1 may output data corresponding to 'sampling pass'. The data corresponding to 'sampling pass' may be, for example, '1'. In another example, when the chip select signal CS is at a low level or in an indeterminate region at the rising edge of the first internal clock signal ICK_1, the first sub-sampler 213_1 may output data corresponding to 'sampling fail'. The data corresponding to 'sampling fail' may be, for example, '0'.

The second sub-sampler 213_2 may receive the chip select signal CS from the training circuit 110 and may receive the second internal clock signal ICK_2 from the internal clock selector 212. The second sub-sampler 213_2 may perform the sampling operation on the low level of the chip select signal CS based on the second internal clock signal ICK_2.

For example, when the chip select signal CS is at a low level at the rising edge of the second internal clock signal ICK_2, the second sub-sampler 213_2 may output data corresponding to 'sampling pass'. The data corresponding to the 'sampling pass' may be, for example, '1'. In another example, when the chip select signal CS is at a high level or in the indeterminate region at the rising edge of the second internal clock signal ICK_2, the second sub-sampler 213_2 may output data corresponding to 'sampling fail'. The data corresponding to the 'sampling fail' may be, for example, '0'.

The register 215 may receive and store the sampling data for the high level of the chip select signal CS from the first sub-sampler 213_1. The register 215 may also receive and store the sampling data for the low level of the chip select signal CS from the second sub-sampler 213_2. In addition, the register 215 may combine the sampling data for the high level and the sampling data for the low level of the chip select signal CS to generate the sampling data SD and may transmit the sampling data SD to the training circuit 110 through a memory data pad DQ_m.

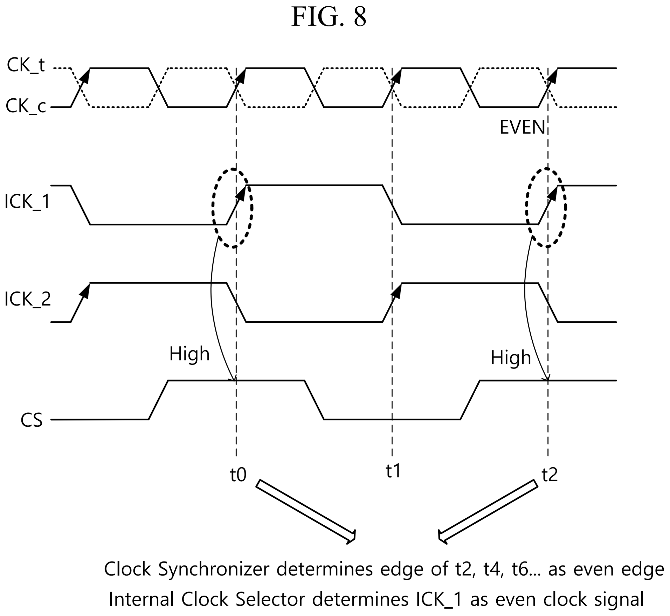

FIG. 8 is a diagram illustrating an operation in which the sampling circuit 210 of FIG. 7 determines the even internal clock signal. For convenience of explanation, FIG. 8 illustrates an example in which the first internal clock signal ICK_1 and the second internal clock signal ICK_2 are selected as the even internal clock signal and the odd internal clock signal, respectively.

Referring to FIGS. 7 and 8, the clock divider 211 may divide the clock signals CK_t and CK_c to generate the first internal clock signal ICK_1 and the second internal clock signal ICK_2. In this case, the frequencies of the first and second internal clock signals ICK_1 and ICK_2 may be one-half of the frequencies of the clock signals CK_t and CK_c.

The clock synchronizer 214 may identify whether the rising edges of the first and second internal clock signals ICK_1 and ICK 2 are aligned with the high level of the chip select signal CS. For example, at time points t0 and t2, the rising edges of the first internal clock signal ICK_1 may sample the high level of the chip select signal CS. In this case, the clock synchronizer 214 may determine the rising edges at time points t0, t2, t4, t6, t8, and so on, as the even edges based on a time point t0. In addition, the clock synchronizer 214 may determine the rising edges at time points t1, t3, t5, t7, and so on, as the odd edges.

The internal clock selector 212 may identify the internal clock signal having the even edge from the first internal clock signal ICK_1 and the second internal clock signal ICK 2 and may determine the identified internal clock signal as the even internal clock signal. For example, the internal clock selector 212 may determine the first internal clock signal ICK_1 as the even internal clock signal to sample the high level of the chip select signal CS. In addition, the internal clock selector 212 may determine the second internal clock signal ICK_2 as the odd internal clock signal to sample the low level of the chip select signal CS.

FIG. 9A is a diagram illustrating the CS training operation according to an implementation of the present disclosure. The CS training operation of FIG. 9A may correspond to the CS training operations of FIGS. 5 through 8. For convenience of explanation, in FIG. 9A, it is assumed that the first internal clock signal ICK_1 and the second internal clock signal ICK_2 are respectively selected as the even internal clock signal and the odd internal clock signal.

Referring to FIG. 9A, in the first step (Step 1), the sampling result for the chip select signal CS may be 'sampling pass'. For example, at the time point t2, the rising edge of the first internal clock signal ICK_1 may sample the high level of the chip select signal CS. At the time point t3, the rising edge of the second internal clock signal ICK_2 may sample the low level of the chip select signal CS. In this case, the training circuit 110 (refer to FIG. 6) may push the chip select signal CS of the first step by a first delay time D1. Then, the second step (Step 2) may be performed.

In the second step (Step 2), the sampling result for the chip select signal CS may be 'sampling fail'. For example, at the time point t2, the rising edge of the first internal clock signal ICK_1 may sample the low level of the chip select signal CS. At the time point t3, the rising edge of the second internal clock signal ICK_2 may sample the high level of the chip select signal CS. In this case, the training circuit 110 may pull the chip select signal CS of the second step by a second delay time D2 based on the sampling fail point so that the center of the chip select signal CS is aligned with the rising edge of the first internal clock signal ICK_1. For example, when one-half of a period of the first internal clock signal ICK_1 is defined as 'T', the second delay time D2 may correspond to 'T/2'.

In the third step (Step 3), since the center of the chip select signal CS is adjusted to be aligned with the rising edge of the first internal clock signal ICK_1, the sampling result for the chip select signal CS may be 'sampling pass'. In addition, the high level of the chip select signal CS may have a setup time and a hold time with a sufficient margin.

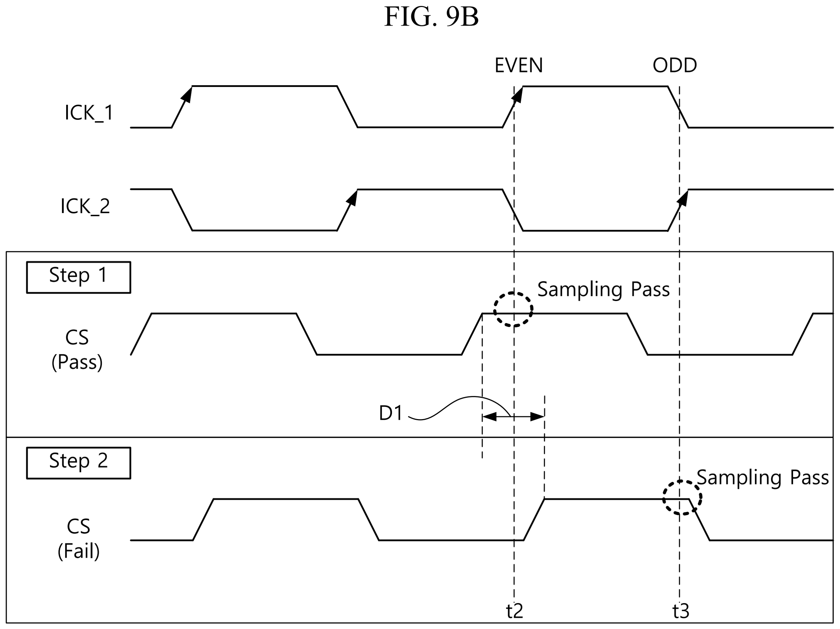

FIG. 9B is a diagram illustrating a CS training operation according to the comparative example. For convenience of explanation, it is assumed that the chip select signal in the first step of FIG. 9B and the chip select signal in the second step of FIG. 9B are the same as the chip select signal in the first step of FIG. 9A and the chip select signal in the second step of FIG. 9A, respectively. In addition, it is assumed that both the first internal clock signal ICK_1 and the second internal clock signal ICK 2 sample the high level of the chip select signal.

Referring to FIG. 9B, in the first step (Step 1), the sampling result for the chip select signal CS may be 'sampling pass'. For example, at the time point t2, the rising edge of the first internal clock signal ICK_1 may sample the high level of the chip select signal CS. In this case, the chip select signal CS may be pushed by a first delay time D1. Then, the second step (Step 2) may be performed.

In the second step (Step 2), the sampling result for the chip select signal CS may be 'sampling pass'. For example, at the time point t3, the rising edge of the second internal clock signal ICK_2 may sample the high level of the chip select signal CS. In this case, the chip select signal CS may be pushed again by the first delay time D1. Then, the second step (Step 2) may be performed.

In comparison with FIG. 9A, the sampling fail is not detected and is skipped in the comparative example of FIG. 9B. This is because the fail detection region in the comparative example is shorter than the first delay time D1. In this case, a time unit for delaying the chip select signal CS is required to be set to a very short time interval to detect the sampling fail. Accordingly, a time required to perform the CS training may increase in the comparative example.

In contrast, as shown in FIGS. 5 to 9A, in the CS training according to implementations of the present disclosure, the clock signal may be divided into the two internal clock signals ICK_1 and ICK_2, the sampling operation on the high level of the chip select signal CS may be performed using the first internal clock signal ICK_1, and the sampling operation on the low level of the chip select signal CS may be performed using the second internal clock signal ICK_2. Accordingly, the region in which the sampling fail is detected may be expanded, and as a result, the CS training may be efficiently performed.

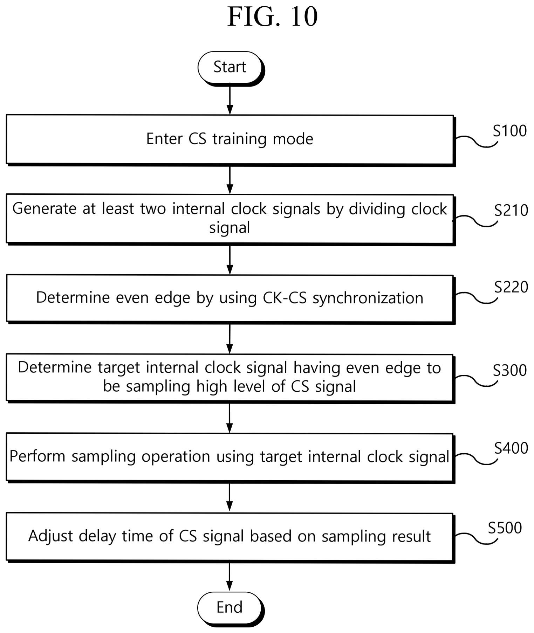

FIG. 10 is a flowchart illustrating an operation of performing the CS training according to an implementation of the present disclosure. The CS training operation of FIG. 10 may be an example of the CS training operation of the memory system of FIGS. 5 to 9A.

The memory system 2000 (refer to FIG. 5) may enter the CS training mode in operation S100.

For example, the memory system 2000 (refer to FIG. 5) may enter the CS training mode under specific conditions such as booting or initialization.

In operation S210, the clock signal may be divided to generate the at least two internal clock signals.

For example, the clock divider 211 (refer to FIG. 7) may divide the clock signal CK by two (2) to generate the two internal clock signals ICK_1 and ICK_2. In this case, the frequency of each of the two internal clock signals ICK_1 and ICK_2 may be one-half (1/2) of the frequency of the clock signal CK.

In operation S220, the even edge may be determined based on the synchronization information between the clock signal and the chip select signal.

For example, the clock synchronizer 214 (refer to FIG. 7) may determine the even edge among the edges of the first and second internal clock signals ICK_1 and ICK 2 based on the alignment between the rising edges of the first and second internal clock signals ICK_1 and ICK_2 and the high level of the chip select signal CS.

In operation S300, the internal clock signal having the even edge from the at least two internal clock signals may be selected as a target internal clock signal to sample the high level of the chip select signal.

For example, the internal clock selector 212 (refer to FIG. 7) may determine the first internal clock signal ICK_1, which has the even edge, of the two internal clock signals ICK_1 and ICK 2 as the even internal clock signal. In this case, the first internal clock signal ICK_1 may be used to sample the high level of the chip select signal CS.

In operation S400, the sampling operation may be performed using the target internal clock signal.

For example, the sampler 213 (refer to FIG. 7) may sample the chip select signal CS at the rising edge of the first internal clock signal ICK_1. When the chip select signal CS is at the high level at the rising edge of the first internal clock signal ICK_1, the sampling result may be 'pass'. When the chip select signal CS is at the low level or is within the indeterminate region at the rising edge of the first internal clock signal ICK_1, the sampling result may be 'fail'.

In operation S500, the delay time of the chip select signal may be adjusted based on the sampling result.

For example, the training circuit 110 (refer to FIG. 5) may adjust the delay time of the chip select signal CS based on the sampling result of the sampler 213. For example, the training circuit 110 may push the chip select signal CS or may pull the chip select signal CS so that the center of the chip select signal CS is aligned with the rising edge of the first internal clock signal ICK_1.

As described above, in the CS training operation according to implementations of the present disclosure, the clock signal may be divided into the two internal clock signals, and the sampling operation on the chip select signal may be performed using one of the two internal clock signals. Accordingly, the region in which the sampling fail is detected may be expanded, and as a result, the CS training may be efficiently performed.

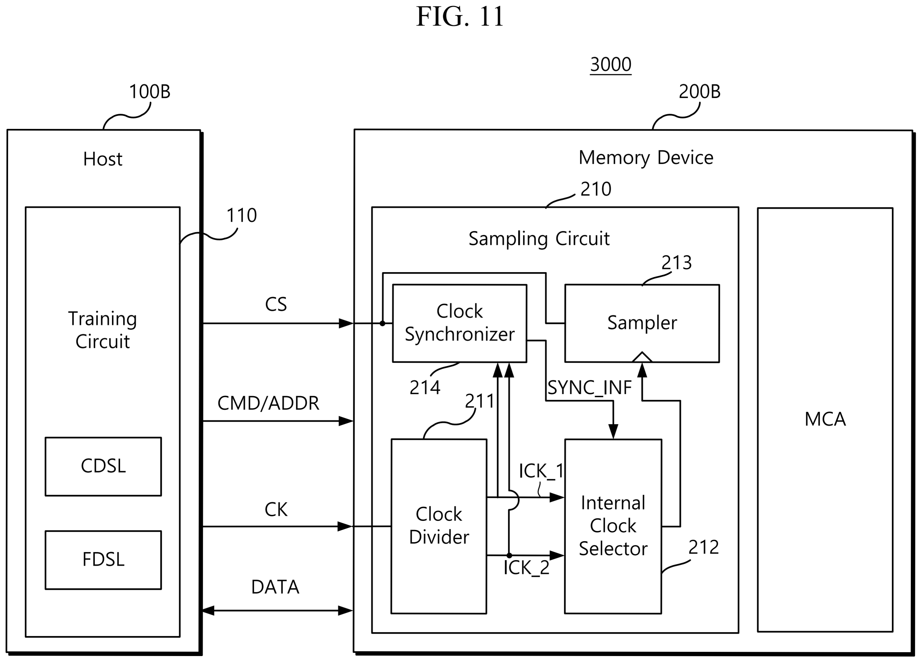

FIG. 11 is a block diagram schematically illustrating a memory system 3000 according to an implementation of the present disclosure. The memory system 3000 of FIG. 11 is similar to the memory systems 1000 and 2000 of FIGS. 1 and 5. Accordingly, in FIG. 11, the same or similar reference numerals denote the same or similar elements in FIGS. 1 and 5, and thus, detailed descriptions of the same or similar elements will be omitted.

Referring to FIG. 11, the memory system 3000 may include a host 100B and a memory device 200B. The host 100B may include a training circuit 110, and the memory device 200B may include a sampling circuit 210 and a memory cell array MCA. The sampling circuit 210 may include a clock divider 211, an internal clock selector 212, a sampler 213, and a clock synchronizer 214.

In an implementation of the present disclosure, the training circuit 110 may support a coarse search operation and a fine search operation. For example, when performing a CS training, the training circuit 110 may first perform the coarse search operation. When a sampling fail is detected through the coarse search operation, the training circuit 110 may perform the fine search operation. For example, the training circuit 110 may include a coarse delay setting logic (CDSL) and a fine delay set logic (FDSL).

The coarse delay setting logic (CDSL) may set a delay time to be applied to a chip select signal CS in the coarse search operation. The fine delay set logic (FDSL) may set a delay time to be applied to the chip select signal CS in the fine search operation. The delay time in the coarse search operation may be longer than the delay time in the fine search operation.

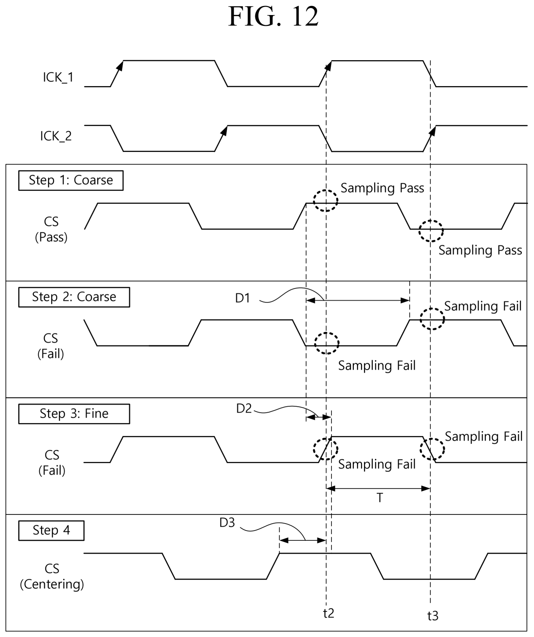

FIG. 12 is a diagram illustrating the CS training operation according to an implementation of the present disclosure. The CS training operation of FIG. 12 may correspond to the CS training operation of the memory system of FIG. 11. For convenience of explanation, in FIG. 12, it is assumed that a first internal clock signal ICK_1 and a second internal clock signal ICK_2 are selected as an even internal clock signal and an odd internal clock signal, respectively.

Referring to FIG. 12, a first step (Step 1) may correspond to the coarse search operation. In the first step (Step 1), a sampling result for the chip select signal CS may be 'sampling pass'. For example, a rising edge of the first internal clock signal ICK_1 may sample a high level of the chip select signal CS at a time point t2, and a rising edge of the second internal clock signal ICK_2 may sample a low level of the chip select signal CS at a time point t3.

In this case, the training circuit 110 (refer to FIG. 11) may push the chip select signal CS of the first step by a first delay time D1. In the present implementation, the first delay time D1 may be a delay time in the coarse search operation. Then, a second step (Step 2) may be performed.

The second step (Step 2) may correspond to the coarse search operation. In the second step (Step 2), the sampling result for the chip select signal CS may be 'sampling fail'. For example, the rising edge of the first internal clock signal ICK_1 may sample the low level of the chip select signal CS at the time point t2, and the rising edge of the second internal clock signal ICK_2 may sample the high level of the chip select signal CS at the time point t3.

When the sampling fail is detected in the coarse search operation, the training circuit 110 may stop the coarse search operation and perform the fine search operation. The training circuit 110 may perform the fine search operation based on the chip select signal CS of the first step rather than the chip select signal CS of the second step. For example, the training circuit 110 may push the chip select signal CS of the first step by a second delay time D2. In the present implementation, the second delay time D2 may be a delay time in the fine search operation and may be shorter than the first delay time. Then, a third step (Step 3) may be performed.

The third step (Step 3) may correspond to the fine search operation. In the third step (Step 3), the sampling result for the chip select signal CS may be 'sampling fail'. For example, the rising edge of the first internal clock signal ICK_1 may sample an indeterminate region of the chip select signal CS at the time point t2, and the rising edge of the second internal clock signal ICK_2 may sample the indeterminate region of the chip select signal CS at the time point t3.

When the sampling fail is detected in the fine search operation, the training circuit 110 may pull the chip select signal CS of the third step by a third delay time D3 based on a sampling fail point so that a center of the chip select signal CS is aligned with the rising edge of the first internal clock signal ICK_1. For example, when one-half of a period of the first internal clock signal ICK_1 is defined as 'T', the third delay time D3 may correspond to 'T/2'.

In a fourth step (Step 4), since the center of the chip select signal CS is adjusted to be aligned with the rising edge of the first internal clock signal ICK_1, the sampling result for the chip select signal CS may be 'sampling pass'. In addition, the high level of the chip select signal CS may have a setup time and a hold time with a sufficient margin.

As described with reference to FIGS. 11 and 12, the CS training according to implementations of the present disclosure may support the coarse search operation and the fine search operation. Accordingly, the sampling fail point may be quickly found, and a CS training time may be reduced. In addition, according to the CS training according to implementations of the present disclosure, a clock signal may be divided into at least two internal clock signals, and the sampling operation on the chip select signal may be performed using one of the at least two internal clock signals. Accordingly, the region in which the sampling fail is detected may be expanded, and as a result, the CS training may be efficiently performed.

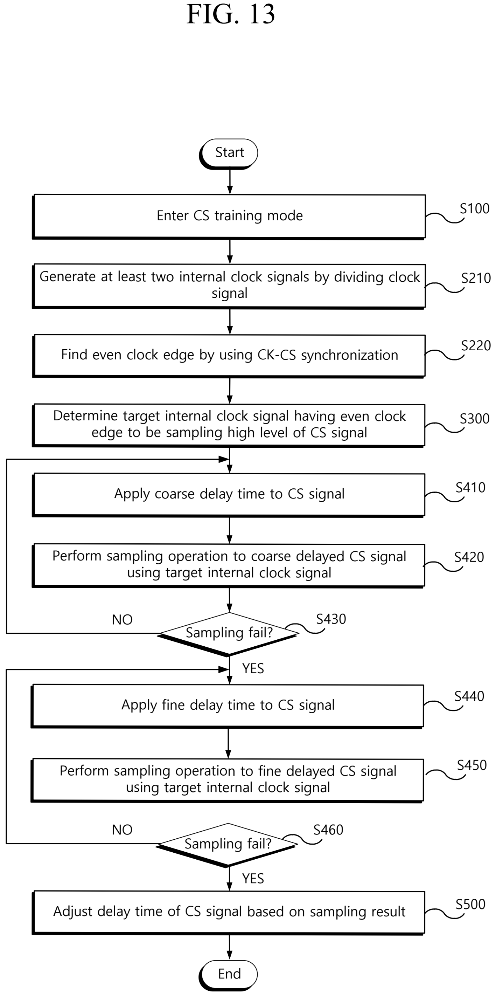

FIG. 13 is a flowchart illustrating an operation of performing the CS training according to an implementation of the present disclosure. The CS training operation of FIG. 13 may be an example of the CS training operation of the memory system of FIGS. 11 and 12.

The memory system 3000 (refer to FIG. 11) may enter the CS training mode in operation S100.

For example, the memory system 3000 (refer to FIG. 11) may enter the CS training mode under specific conditions such as booting or initialization.

In operation S210, the clock signal may be divided to generate at least two internal clock signals.

For example, the clock divider 211 (refer to FIG. 11) may divide the clock signal CK by two (2) and thereby generate the two internal clock signals ICK_1 and ICK_2. In this case, the frequency of each of the two internal clock signals ICK_1 and ICK_2 may be one-half (1/2) of the frequency of the clock signal CK.

In operation S220, an even edge may be determined based on synchronization information between the clock signal and the chip select signal.

For example, the clock synchronizer 214 (refer to FIG. 11) may determine the even edge among the edges of the first and second internal clock signals ICK_1 and ICK 2 based on alignment between the rising edges of the first and second internal clock signals ICK_1 and ICK_2 and the high level of the chip select signal CS.

In operation S300, the internal clock signal having the even edge from the at least two internal clock signals may be selected as a target internal clock signal to sample the high level of the chip select signal.

For example, the internal clock selector 212 (refer to FIG. 11) may determine the first internal clock signal ICK_1, which has the even edge, of the two internal clock signals ICK_1 and ICK 2 as the even internal clock signal. In this case, the first internal clock signal ICK_1 may be used to sample the high level of the chip select signal CS.

In operation S410, a coarse delay time may be provided to the chip select signal CS.

For example, the coarse delay set logic CDSL (refer to FIG. 11) may set the coarse delay time, and the chip select signal CS may be pushed by the coarse delay time.

In operation S420, the sampling operation may be performed on the chip select signal CS to which the coarse delay is applied using the target internal clock signal.

For example, the sampler 213 (refer to FIG. 11) may sample the chip select signal CS at the rising edge of the first internal clock signal ICK_1.

In operation S430, it may be determined whether the sampling result is 'fail'.

When the chip select signal CS is at the high level at the rising edge of the first internal clock signal ICK_1, the sampling result may be 'pass'. In this case, the coarse search operation may be continuously performed. That is, operation S410 may be performed again, and the chip select signal CS may be further pushed by the coarse delay time.

When the chip select signal CS is at the low level or is in the indeterminate region at the rising edge of the first internal clock signal ICK_1, the sampling result may be 'fail'. In this case, the coarse search operation may be completed, and the fine search operation may be performed. That is, operation S440 may be performed.

In operation S440, a fine delay time may be provided to the chip select signal CS.

For example, the fine delay set logic (FDSL) (refer to FIG. 11) may set the fine delay time, and the chip select signal CS may be pushed by the fine delay time.

In operation S450, the sampling operation may be performed on the chip select signal CS to which the fine delay is applied using the target internal clock signal.

For example, the sampler 213 may sample the chip select signal CS at the rising edge of the first internal clock signal ICK_1.

In operation S460, it may be determined whether the sampling result is 'fail'.

When the chip select signal CS is at the high level at the rising edge of the first internal clock signal ICK_1, the sampling result may be 'pass'. In this case, the fine search operation may be continuously performed. That is, operation S440 may be performed again, and the chip select signal CS may be further pushed by the fine delay time.

When the chip select signal CS is at the low level or is in the indeterminate region at the rising edge of the first internal clock signal ICK_1, the sampling result may be 'fail'. In this case, the fine search operation may be completed, and the operation to align the center of the chip select signal CS with the rising edge may be performed. That is, operation S500 may be performed.

In operation S500, the delay time of the chip select signal may be adjusted based on the sampling result.

For example, the training circuit 110 (refer to FIG. 11) may adjust the delay time of the chip select signal CS based on the sampling result of the sampler 213. For example, the training circuit 110 may push the chip select signal CS or pull the chip select signal CS to align the center of the chip select signal CS with the rising edge of the first internal clock signal ICK_1.

As described above, the CS training operation according to implementations of the present disclosure may support the coarse search operation and the fine search operation. Accordingly, the sampling fail time point may be quickly found, and the CS training time may be reduced. In addition, the CS training operation according to implementations of the present disclosure may divide the clock signal into the two internal clock signals and may perform the sampling operation on the chip select signal using one of the two internal clock signals. Accordingly, the region in which the sampling fail is detected may be expanded, and as a result, the CS training may be efficiently performed.

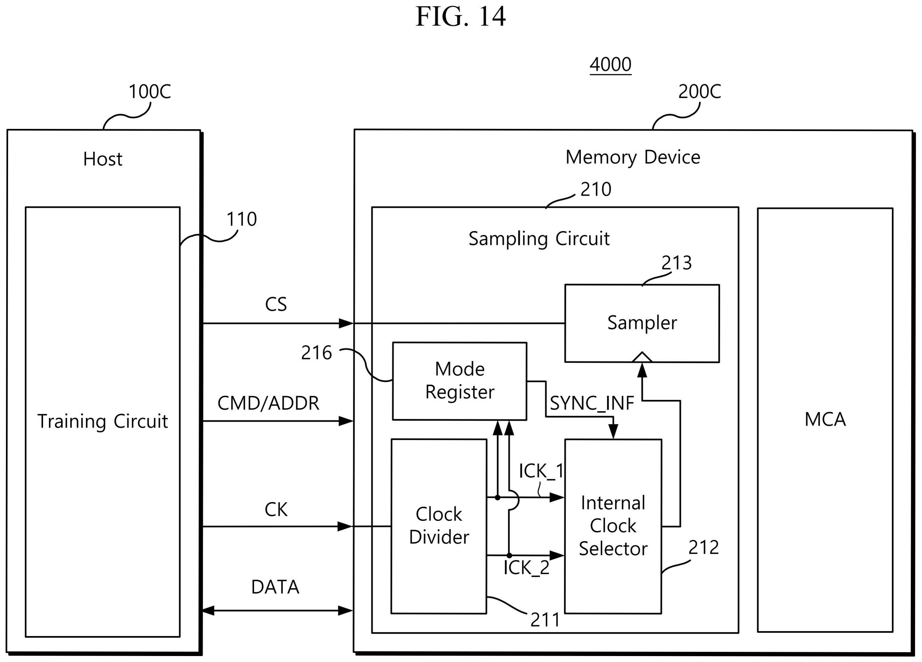

FIG. 14 is a block diagram schematically illustrating a memory system 4000 according to an implementation of the present disclosure. The memory system 4000 of FIG. 14 is similar to the memory systems 1000, 2000, and 3000 of FIGS. 1, 5, and 11. Accordingly, in FIG. 14, the same or similar reference numerals denote the same or similar elements in FIGS. 1, 5, and 11, and thus, detailed descriptions of the same or similar elements will be omitted.

Referring to FIG. 14, the memory system 4000 may include a host 100C and a memory device 200C. The host 100C may include a training circuit 110, and the memory device 200C may include a sampling circuit 210 and a memory cell array MCA. The sampling circuit 210 may include a clock divider 211, an internal clock selector 212, a sampler 213, and a mode register 216.

In an implementation of the present disclosure, the mode register 216 may receive at least two internal clock signals from the clock divider 211. The mode register 216 may determine an even edge among edges of the at least two internal clock signals. In other words, when setting a mode register, the mode register 216 may receive the at least two internal clock signals from the clock divider 211 and may classify the edges of the at least two internal clock signals into even edges and odd edges. The mode register 216 may provide synchronization information SYNC_INF on the even edge to the internal clock selector 212.

In an implementation, information to determine the even edges among the edges of the at least two internal clock signals may be previously stored in the mode register 216. The memory device 200C may determine the even edge among the edges of the at least two internal clock signals based on the information stored in the mode register 216.

As described above, the sampling circuit 210 may determine the even edge using the mode register 216 instead of a clock synchronizer.

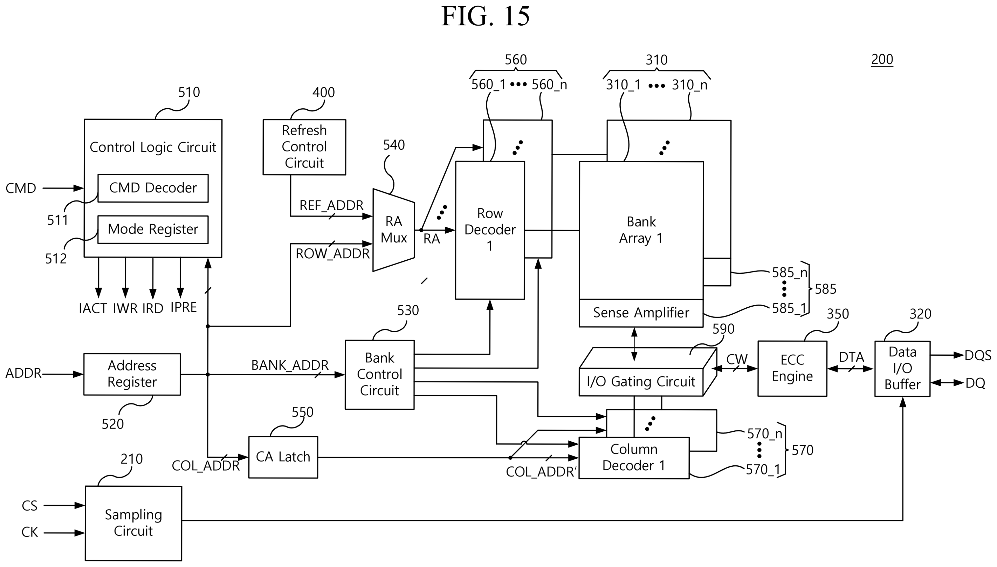

FIG. 15 is a block diagram illustrating a memory device 200 according to an implementation of the present disclosure. The memory device 200 of FIG. 15 may correspond to the memory devices 200, 200A, 200B, and 200C of FIGS. 1 to 14.

Referring to FIG. 15, the memory device 200 may include a sampling circuit 210, a memory cell array 310, a data input/output buffer 320, an ECC engine 350, a refresh control circuit 400, a control logic circuit 510, an address register 520, a bank control circuit (or logic) 530, a row address multiplexer 540, a column address latch 550, a row decoder 560, a column decoder 570, a sense amplifier part 585, and an input/output gating circuit 590.

In the present implementation, during CS training, the sampling circuit 210 may divide a clock signal into at least two internal clock signals and may perform a sampling operation on a chip select signal using one of the at least two internal clock signals. The sampling circuit 210 may correspond to the sampling circuit 210 described with reference to FIGS. 1 to 14.

The memory cell array 310 may include a plurality of bank arrays 310_1 to 310_n. Each of the bank arrays 310_1 to 310_n may include a plurality of memory cells. For example, each of the memory cells may be formed at a point where a corresponding word line and a bit line intersect.

The row decoder 560 may include a plurality of sub-row decoders 560_1 to 560_n. Each of the sub-row decoders 560_1 to 560_n may be connected to a corresponding bank array among the bank arrays 310_1 to 310_n.

The sense amplifier part 585 may include a plurality of sense amplifiers 585_1 to 585_n. Each of the sense amplifiers 585_1 to 585_n may be connected to a corresponding bank array among the bank arrays 310_1 to 310_n.

The column decoder 570 may include a plurality of sub-column decoders 570_1 to 570_n. Each of the sub-column decoders 570_1 to 570_n may be connected to a corresponding bank array among the bank arrays 310_1 to 310_n through a corresponding sense amplifier.

The bank arrays 3 10_1 to 3 10_n, the sense amplifiers 585_1 to 585_n, the column decoders 570_1 to 570_n, and the row decoders 560_1 to 560_n may constitute a plurality of banks. For example, a first bank array 310_1, a first sense amplifier 585_1, a first column decoder 570_1, and a first row decoder 560_1 may constitute a first bank.

The address register 520 may receive an address ADDR including a bank address BANK_ADDR, a row address ROW_ADDR, and a column address COL_ADDR from a memory controller. The address register 520 may provide the received bank address BANK_ADDR to the bank control logic 530, may provide the received row address ROW_ADDR to the row address multiplexer 540, and may provide the received column address COL_ADDR to the column address latch 550.

The bank control logic 530 may generate bank control signals in response to the bank address BANK_ADDR. For example, a row decoder corresponding to the bank address BANK_ADDR among the row decoders 560_1 to 560_n may be activated in response to the bank control signals. A column decoder corresponding to the bank address BANK_ADDR among the column decoders 570_1 to 570_n may be activated in response to the bank control signals.

The row address multiplexer 540 may receive the row address ROW_ADDR from the address register 520 and may receive a refresh row address REF_ADDR from the refresh control circuit 400. The row address multiplexer 540 may selectively output the row address ROW_ADDR or the refresh row address REF_ADDR as a row address RA. The row address RA output from the row address multiplexer 540 may be applied to each of the row decoders 560_1 to 560_n.

The refresh control circuit 400 may sequentially increase or decrease the refresh row address REF_ADDR in a normal refresh mode in response to refresh signals from the control logic circuit 510.

In a hammer refresh mode, the refresh control circuit 400 may receive a hammer address HADDR. Based on the hammer address HADDR, the refresh control circuit 400 may output addresses of adjacent memory cell rows adjacent to an aggressor memory cell row as the refresh row address REF_ADDR.

A row decoder selected by the bank control logic 530 among the row decoders 560_1 to 560_n may activate a word line corresponding to the row address RA output from the row address multiplexer 540. For example, the selected row decoder may apply a word line driving voltage to the word line corresponding to the row address.

The column address latch 550 may receive the column address COL_ADDR from the address register 520 and may temporarily store the received column address COL_ADDR. In addition, for example, in a burst mode, the column address latch 550 may gradually increase the received column address COL_ADDR. The column address latch 550 may apply the temporarily stored or gradually increased column address COL_ADDR' to each of the column decoders 570_1 to 570_n.

A column decoder activated by the bank control logic 530 among the column decoders 570_1 to 570_n may activate a sense amplifier corresponding to the bank address BANK_ADDR and the column address COL_ADDR through the input/output gating circuit 590.

The input/output gating circuit 590 may include circuits for gating input and output data. In addition, the input/output gating circuit 590 may include data latches to store codewords output from the bank arrays 310_1 to 310_n, and write drivers to write data into the bank arrays 310_1 to 310_n.

In an implementation, during a read operation, a codeword CW read from a selected bank array among the bank arrays 310_1 to 310_n may be sensed by a sense amplifier corresponding to the selected bank array and may be stored in data latches of the input/output gating circuit 590. In addition, the codeword CW stored in the data latches may be provided to the data input/output buffer 320 as data DTA through ECC decoding by the ECC engine 350. The data input/output buffer 320 may generate a data signal DQ based on the data DTA and may provide the data signal DQ to the memory controller together with a strobe signal DQS.

In an implementation, during a write operation, data DTA to be written into a selected bank array among the bank arrays 310_1 to 310_n may be received by the data input/output buffer 320 as the data signal DQ. The data input/output buffer 320 may convert the data signal DQ into the data DTA and may provide the data DTA to the ECC engine 350. The ECC engine 350 may generate parity bits (or parity data) based on the data DTA and may provide the codeword CW including the data DTA and the parity bits to the input/output gating circuit 590. The input/output gating circuit 590 may write the codeword CW into the selected bank array.

During the write operation, the data input/output buffer 320 may convert the data signal DQ into the data DTA and provide the data DTA to the ECC engine 350. During the read operation, the data input/output buffer 320 may convert the data DTA provided from the ECC engine 350 into the data signal DQ.

The ECC engine 350 may perform ECC encoding on the data DTA during the write operation. The ECC engine 350 may perform the ECC decoding on the codeword CW during the read operation.

In addition, the ECC engine 350 may perform the ECC encoding and the ECC decoding on count data CNTD provided from the row hammer management circuit 500.

The control logic circuit 510 may control operations of the memory device 200. For example, the control logic circuit 510 may generate control signals so that the memory device 200 performs the write operation, the read operation, the normal refresh operation, and the hammer refresh operation. The control logic circuit 510 may include a command decoder 511 to decode a command CMD received from the memory controller and a mode register set (MRS) 512 to set an operation mode of the memory device 200.

The command decoder 511 may decode the command CMD to generate internal command signals such as an internal active signal IACT, an internal precharge signal IPRE, an internal read signal IRD, and an internal write signal IWR. In addition, the command decoder 511 may decode the chip select signal and the command/address signals to generate control signals corresponding to the command CMD.

The above description relates to specific implementations for implementing the present disclosure. The present disclosure is not limited to the above-described implementations, and also includes implementations that may be achieved through simple design modifications or easy alternations.

For example, in FIGS. 1 to 15, the technical concept of the present disclosure has been described as being applied to the CS training. However, it will be readily understood that the technical concept of the present disclosure may also be applied to training processes of the command/address signals CMD/ADDR or the data DATA, as well as to devices that perform such training.

In addition, for example, in FIGS. 1 to 15, the memory device has been mainly described as a single chip. However, it will be readily understood that the technical concept of the present disclosure may also be applied to memory modules such as UDIMM (Unbuffered Dual In-Line Memory Module), RDIMM (Registered DIMM), and LRDIMM (Load Reduced DIMM), or to HBM (High Bandwidth Memory) such as HBM1, HBM2, HBM3, and HBM4.

In addition, for example, in FIGS. 1 to 15, the role of the internal clock signal has been described as being designated by the memory device. However, this is merely an example and the present disclosure is not limited thereto. According to implementations, the role of the internal clock signal may be designated by the host according to a mutually agreed selection method between the memory device and the host. Further, as described above, the roles of the internal clock signal may be mutually exchanged.

Embodiments are set out in the following clauses:
Clause 1. A memory device comprising: a clock divider configured to receive a clock signal from a host, divide the clock signal, and generate at least two internal clock signals; an internal clock selector configured to receive the at least two internal clock signals from the clock divider and select one of the at least two internal clock signals as a target internal clock signal; and a sampler configured to receive a chip select signal from the host, receive the target internal clock signal from the internal clock selector, and sample the chip select signal using the target internal clock signal.
Clause 2. The memory device of Clause 1, wherein the at least two internal clock signals generated by the clock divider comprise a first internal clock signal and a second internal clock signal, and wherein the internal clock selector is configured to: select the first internal clock signal as a first target internal clock signal to sample a high level of the chip select signal, and select the second internal clock signal as a second target internal clock signal to sample a low level of the chip select signal.
Clause 3. The memory device of Clause 2, wherein the sampler comprises: a first sub-sampler configured to receive the first target internal clock signal and the chip select signal and sample the high level of the chip select signal using the first target internal clock signal; and a second sub-sampler configured to receive the second target internal clock signal and the chip select signal and sample the low level of the chip select signal using the second target internal clock signal.
Clause 4. The memory device of Clause 3, comprising a register configured to store a first sub-sampling result received from the first sub-sampler and store a second sub-sampling result received from the second sub-sampler, wherein the first sub-sampling result and the second sub-sampling result are transmitted to the host as sampling data through a data pad.
Clause 5. The memory device of any preceding Clause, comprising a clock synchronizer configured to receive the at least two internal clock signals from the clock divider, receive the chip select signal from the host, and classify edges of the at least two internal clock signals into even edges and odd edges.
Clause 6. The memory device of Clause 5, wherein the clock synchronizer is configured to determine the even edges among the edges of the at least two internal clock signals based on synchronization information between the chip select signal and the at least two internal clock signals.
Clause 7. The memory device of Clause 6, wherein the internal clock selector is configured to select an internal clock signal comprising the even edges from the at least two internal clock signals as the target internal clock signal.
Clause 8. The memory device of Clause 5, 6 or 7, wherein a command is received from the host at the even edges.
Clause 9. The memory device of any preceding Clause, comprising a mode register configured to receive the at least two internal clock signals from the clock divider and store information for classifying edges of the at least two internal clock signals into even edges and odd edges.
Clause 10. The memory device of any preceding Clause, wherein the chip select signal is delayed by a first delay time during a coarse search operation, the chip select signal is delayed by a second delay time during a fine search operation, and the first delay time is longer than the second delay time.
Clause 11. The memory device of any preceding Clause, wherein a frequency of each of the at least two internal clock signals is one-half (1/2) of a frequency of the clock signal.
Clause 12. A method of operating a memory device, comprising: dividing, during a training mode with respect to a chip select signal, a clock signal to generate at least two internal clock signals; selecting one of the at least two internal clock signals as a target internal clock signal; sampling the chip select signal using the target internal clock signal; and adjusting a delay time to be applied to the chip select signal based on a result of sampling the chip select signal.
Clause 13. The method of Clause 12, comprising determining even edges among edges of the at least two internal clock signals based on synchronization information between the clock signal and an internal clock signal of the at least two internal clock signals.
Clause 14. The method of Clause 13, wherein selecting the one of the at least two internal clock signals comprises: selecting, as the target internal clock signal, an internal clock signal comprising the even edges from the at least two internal clock signals.
Clause 15. The method of Clause 12, 13 or 14, comprising: applying a coarse delay time to the chip select signal to generate a first chip select signal; sampling the first chip select signal using the target internal clock signal; determining that a result of sampling the first chip select signal is pass or fail; and applying, based on the result of sampling the first chip select signal being pass, the coarse delay time to the first chip select signal to generate a second chip select signal.
Clause 16. The method of Clause 15, comprising, based on the result of sampling the first chip select signal being fail, applying a fine delay time to the chip select signal to generate a third chip select signal.
Clause 17. The method of Clause 16, comprising: determining that a result of sampling the third chip select signal is pass or fail; and applying, based on the result of sampling the third chip select signal being pass, the fine delay time to the third chip select signal to generate a fourth chip select signal.
Clause 18. The method of Clause 17, wherein, based on the result of sampling the third chip select signal being fail, adjusting the delay time to be applied to the third chip select signal, based on a sampling fail point with respect to the third chip select signal.
Clause 19. The method of Clause 16, 17 or 18, wherein the coarse delay time is longer than the fine delay time.
Clause 20. A memory system comprising: a memory device; and a host configured to provide a clock signal and a chip select signal to the memory device during a training with respect to a chip select signal, wherein the memory device comprises: a clock divider configured to divide the clock signal received from the host and generate at least two internal clock signals; an internal clock selector configured to receive the at least two internal clock signals from the clock divider and select one of the at least two internal clock signals as a target internal clock signal; and a sampler configured to receive the chip select signal from the host, receive the target internal clock signal from the internal clock selector, and sample the chip select signal using the target internal clock signal.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Moreover, the present disclosure may include technologies that can be easily modified and implemented using the implementations described above. Therefore, the scope of the present disclosure should not be limited to the above-described implementations, but should be determined by the appended claims.

## Claims

1. A memory device comprising:
a clock divider (211) configured to receive a clock signal (CK) from a host (100A), divide the clock signal (CK), and generate at least two internal clock signals (ICK_1, ICK _2);
an internal clock selector (212) configured to receive the at least two internal clock signals (ICK_1, ICK_2) from the clock divider (211) and select one of the at least two internal clock signals (ICK_1, ICK_2) as a target internal clock signal; and
a sampler (213) configured to receive a chip select signal (CS) from the host (100A), receive the target internal clock signal from the internal clock selector (212), and sample the chip select signal (CS) using the target internal clock signal.

2. The memory device of claim 1, wherein the at least two internal clock signals (ICK_1, ICK_2) generated by the clock divider (211) comprise a first internal clock signal (ICK_1) and a second internal clock signal (ICK_2), and
wherein the internal clock selector (212) is configured to:
select the first internal clock signal (ICK_1) as a first target internal clock signal to sample a high level of the chip select signal (CS), and
select the second internal clock signal (ICK_2) as a second target internal clock signal to sample a low level of the chip select signal (CS).

3. The memory device of claim 2, wherein the sampler (213) comprises:
a first sub-sampler (213_1) configured to receive the first target internal clock signal and the chip select signal (CS) and sample the high level of the chip select signal (CS) using the first target internal clock signal; and
a second sub-sampler (213_2) configured to receive the second target internal clock signal and the chip select signal (CS) and sample the low level of the chip select signal (CS) using the second target internal clock signal.

4. The memory device of claim 3, comprising a register (215) configured to store a first sub-sampling result received from the first sub-sampler (213_1) and store a second sub-sampling result received from the second sub-sampler (213_2),
wherein the first sub-sampling result and the second sub-sampling result are transmitted to the host (100A) as sampling data through a data pad.

5. The memory device of any preceding claim, comprising a clock synchronizer (214) configured to receive the at least two internal clock signals (ICK_1, ICK_2) from the clock divider (211), receive the chip select signal (CS) from the host (100A), and classify edges of the at least two internal clock signals (ICK_1, ICK_2) into even edges and odd edges.

6. The memory device of claim 5, wherein the clock synchronizer (214) is configured to determine the even edges among the edges of the at least two internal clock signals (ICK_1, ICK_2) based on synchronization information between the chip select signal (CS) and the at least two internal clock signals (ICK_1, ICK _2).

7. The memory device of claim 6, wherein the internal clock selector (212) is configured to select an internal clock signal (ICK_1, ICK_2) comprising the even edges from the at least two internal clock signals (ICK_1, ICK_2) as the target internal clock signal.

8. The memory device of claim 5, 6 or 7, wherein a command is received from the host (100A) at the even edges.

9. The memory device of any preceding claim, comprising a mode register (216) configured to receive the at least two internal clock signals (ICK_1, ICK_2) from the clock divider (211) and store information for classifying edges of the at least two internal clock signals (ICK_1, ICK_2) into even edges and odd edges.

10. The memory device of any preceding claim, wherein the chip select signal (CS) is delayed by a first delay time (D1) during a coarse search operation, the chip select signal (CS) is delayed by a second delay time (D2) during a fine search operation, and the first delay time is longer than the second delay time.

11. The memory device of any preceding claim, wherein a frequency of each of the at least two internal clock signals (ICK_1, ICK_2) is one-half, 1/2, of a frequency of the clock signa (CS)l.

12. A method of operating a memory device, comprising:
dividing, during a training mode with respect to a chip select signal, a clock signal to generate at least two internal clock signals (S210);
selecting one of the at least two internal clock signals as a target internal clock signal (S300);
sampling the chip select signal using the target internal clock signal (S400); and
adjusting a delay time to be applied to the chip select signal based on a result of sampling the chip select signal (S500).

13. The method of claim 12, comprising determining even edges among edges of the at least two internal clock signals based on synchronization information between the clock signal and an internal clock signal of the at least two internal clock signals (S220).

14. The method of claim 13, wherein selecting the one of the at least two internal clock signals comprises:
selecting, as the target internal clock signal, an internal clock signal comprising the even edges from the at least two internal clock signals (S300).

15. The method of claim 12, 13 or 14, comprising:
applying a coarse delay time to the chip select signal to generate a first chip select signal (S410);
sampling the first chip select signal using the target internal clock signal (S420);
determining that a result of sampling the first chip select signal is pass or fail (S430); and
applying, based on the result of sampling the first chip select signal being pass, the coarse delay time to the first chip select signal to generate a second chip select signal (S410);
based on the result of sampling the first chip select signal being fail, applying a fine delay time to the chip select signal to generate a third chip select signal (S440);
determining that a result of sampling the third chip select signal is pass or fail (S460); and
applying, based on the result of sampling the third chip select signal being pass, the fine delay time to the third chip select signal to generate a fourth chip select signal (S440);
based on the result of sampling the third chip select signal being fail, adjusting the delay time to be applied to the third chip select signal, based on a sampling fail point with respect to the third chip select signal (S500).
